## Europäisches Patentamt

## European Patent Office

## Office européen des brevets

(19)

(11) Publication number: **0 001 139**
**B1**

(12) **EUROPEAN PATENT SPECIFICATION**

(45) Date of publication of patent specification: **28.04.82**

(51) Int. Cl.³: **H 01 L 31/10, H 01 L 31/18**

(21) Application number: **78200152.3**

(22) Date of filing: **23.08.78**

(54) Radiation-sensitive avalanche diode and method of manufacturing same.

(30) Priority: **01.09.77 NL 7709618**

(43) Date of publication of application:
**21.03.79 Bulletin 79/6**

(45) Publication of the grant of the patent:
**28.04.82 Bulletin 82/17**

(84) Designated Contracting States:
**DE FR GB NL SE**

(56) References cited:
**DE - A - 2 337 817**
**FR - A - 2 330 149**

**ELECTRONICS LETTERS, vol. 14, nr. 3, 2 February 1978**
**Hitchin, Herts (GB)**
**J. J. GOEDBLOED et al. "Very low noise silicon planar avalanche photodiodes", pages 67—69**

**IEEE TRANSACTIONS ON ELECTRON DEVICES,**
**vol. ED—23, nr. 12 December 1976 New York, H. KANBE et al. "Silicon avalanche photodiodes with low multiplication noise and high-speed response", pages 1337—1343**

(73) Proprietor: **N.V. Philips' Gloeilampenfabrieken**
**Pieter Zeemanstraat 6**
**NL-5621 CT Eindhoven (NL)**

(72) Inventor: **Smeets, Eugenius Theodorus Josephus Maria**
**c/o INTERN. OCTROOIBUREAU B.V. 6, Prof. Holstlaan**
**NL-5600 Eindhoven (NL)**

(74) Representative: **Wolters, Albert et al,**
**INTERNATIONAAL OCTROOIBUREAU B.V. Prof. Holstlaan 6**
**NL-5656 AA Eindhoven (NL)**

(56) References cited:
**JOURNAL OF THE APPLIED PHYSICS, vol. 47, nr. 7, July 1976**
**New York**
**T. KANEDA et al. "A model for reach-through avalanche photodiodes (RAPD's)", pages 3135—3139**

## Radiation-sensitive avalanche diode and method of manufacturing same

The invention relates to a semiconductor device having an avalanche diode for detecting radiation, comprising a semiconductor body having a semiconductor layer structure of a first conductivity type, which layer structure comprises successively at least a first semiconductor layer of substantially homogeneous, low doping a second semiconductor layer having a doping concentration which is higher than the doping concentration of the first layer, and a third semiconductor layer having a lower doping concentration than the second layer, a first contact layer being present at one side of the layer structure and forming a non-rectifying junction with the neighbouring first semiconductor layer, a second contact layer being present at a side of the layer structure opposite to said one side and forming a rectifying junction with the neighbouring semiconductor layer of the layer structure.

The invention also relates to a method of manufacturing the device.

A semiconductor device of the kind described is known from Philips Technical Review, vol. 36 (1976) *pp.* 205—210.

Semiconductor devices of a variety of natures may be used for detecting radiation. The radiation may be both of a corpuscular nature and of an electromagnetic nature. Although in this application the detection of electromagnetic radiation will mainly be described, the device according to the invention is not restricted to the detection of electromagnetic radiation. In principle the device may be used for the detection of any type of radiation which can generate electron-hole pairs in a semiconductor crystal lattice by absorption of energy.

For the detection of in particular electromagnetic radiation, radiation-sensitive resistors, diodes and transistors usually referred to as photoresistors, photodiodes and phototransistors, are used. Which of these devices is to be preferred for a given application is determined by various factors, *inter alia* the response time, the quantum efficiency, the noise properties and the possible amplification. For many applications the so-called avalanche photodiode is preferred due to its internal amplification and its very short response time. This is the case in particular in optical communication systems.

The ordinary photoavalanche diode has a PN junction which is biased in the reverse direction to such a voltage that avalanche multiplication of charge carriers which are generated by incident radiation in the depletion zone occurs. The field strength distribution over the successive semiconductor layers, however, is comparatively unfavourable. With the minimum thickness of the depletion zone which is required to achieve a reasonable quantum efficiency (for example, for radiation having a wavelength of approximately 0.9 micron in a $P^+PN^+$ silicon diode approximately 25 microns), the voltage across the diode is consequently comparatively high, which is undesired in many applications.

It has been endeavoured to improve this by using a $N^+P\pi P^+$ (or $P^+N\nu N^+$) structure, wherein $\pi$ and $\nu$ respectively, denote very low doped P and N types. As a result of this the field distribution is changed so that with the same thickness of the depletion zone and with the same value of the maximum field strength the overall voltage across the diode is considerably lower than in a $P^+PN^+$ diode. A disadvantage in an $N^+P\pi P^+$ diode, however, is that the avalanche multiplication which takes place in the P region which for technological reasons usually is comparatively thin, must occur over a sufficient width so as to achieve the desired multiplication. Consequently the maximum field strength becomes high resulting in a higher noise factor.

In order to improve this, a $N^+PP^+\pi P^+$ structure has been suggested, see the already mentioned publication in Philips Technical Review. Using this structure the rate of change of field strength across the $PP^+$ region becomes less and the avalanche region becomes wider so as that a reasonable avalanche multiplication can be effected with lower values of the maximum field strength. With this structure a very low noise factor can be obtained.

One of the objects of the invention is to provide an avalanche diode for detecting radiation in which the noise is significantly reduced as compared with the last-mentioned structure. The invention is *inter alia* based on the recognition of the fact that the end in view can be reached by the addition of a further layer or layer portion having a suitably chosen doping.

For that purpose, a semiconductor device of the kind described in the preamble is characterized according to the invention in that the layer structure comprises between the second contact layer and the third semiconductor layer a fourth semiconductor layer of the first conductivity type having a doping concentration which is higher than that of the third semiconductor layer.

It has been found that the addition of the said fourth semiconductor layer involves an unexpected improvement of the noise properties. The reason for this improvement is not yet clearly understood. The fact that in the absence of the fourth semiconductor layer, with a comparatively low and homogeneously doped third layer, the electric field throughout the thickness of said layer is substantially constant so that the ionisation coefficient $\alpha$ for electrons and $\beta$ for holes each individually are also constant throughout the whole thickness of the third layer, presumably plays a part. The noise capacity is proportional to $M^2 (2+k.M)$, wherein M is the multiplication factor, and $k$ is a factor which depends *inter alia* on the spatial variation of $\alpha$ and $\beta$ in the layer in which avalanche multiplication occurs. For a methematical expression for $k$ reference is made to RCA Review Vol. 35 (1974) pp. 234—278, see in particular the formulae (16) and (17) on pages 244 and 245. In the absence of this variation, the value of $k$ can become less favourable. The improvement which is produced by the inventional, however, does not depend on the correct explanation of the observed phenomenon.

Preferred embodiments of the device according to the invention have additional characteristic features which are stated in claims 2 to 15.

A device as described in the preamble and in the first part of claim 1 is known also from FR - A - 2 330 149. In addition in this FR - A - 2 330 149 the characteristic features of claims 5, 6, 8, 9, 11, 14 and 15 are disclosed. Furthermore, from the FR - A - 2 330 149 devices are known in which the second contact layer is formed by a semiconductor layer of the second conductivity type which forms a p-n junction with the neighbouring layer, cf. claim 7 and in which the belt-like zone along its whole inner circumference adjoins the second and third semiconductor layers, cf. claim 10. The additional characteristics of claim 12 are known from the Journal of Applied Physics, Vol. 47, No. 7, July 1976, pages 3135—3139, especially page 3135.

The desired doping profile can be realised in a very suitable and reproducible manner by an efficacious chosen combination of ion implantation and epitaxial growth. In connection herewith, a method of manufacturing the device according to the invention is characterized in that starting material is a semiconductor substrate which serves as the first contact layer, that a low-doped first epitaxial semiconductor layer of the first conductivity type is grown on said substrate, that ions of a dopant determining the first conductivity type are implanted into said first epitaxial semiconductor layer so as to obtain first and second portions of the first epitaxial semiconductor layer which form the first and second semiconductor layer, that a second epitaxial semiconductor layer of the first conductivity type having a lower doping than the second semiconductor layer is then grown on the first epitaxial semiconductor layer with the second semiconductor layer implanted therein, that ions determining the first conductivity type are implanted into said second epitaxial semiconductor layer so as to obtain third and fourth portions of the second epitaxial semiconductor layer which form the third and fourth semiconductor layer.

Preferred embodiments of the method of manufacturing the device according to the invention have additional characteristic features which are stated in claims 17 to 20.

A few ways of carrying out the invention will now be described in greater detail with reference to the drawings, in which .

Fig. 1 is a diagrammatic cross-sectional view of a photoavalanche diode illustrating one way of carrying out the invention,

Fig. 2 shows diagrammatically the doping profile taken on the line II—II of the diode shown in Fig. 1,

Figs. 3 to 7 are diagrammatic cross-sectional views of the device shown in Fig. 1 in successive stages of its manufacture,

Fig. 8 shows the doping profile of a device illustrating another way of carrying out the invention, and

Fig. 9 is a diagrammatic cross-sectional view of a further way of carrying out the invention.

The figures are diagrammatic and not drawn to scale, the dimensions in the thickness direction being exaggerated for clarity.

Corresponding parts are generally referred to by the same reference numerals. Semiconductor regions of the same conductivity type are generally shaded in the same direction in the cross-sectional views.

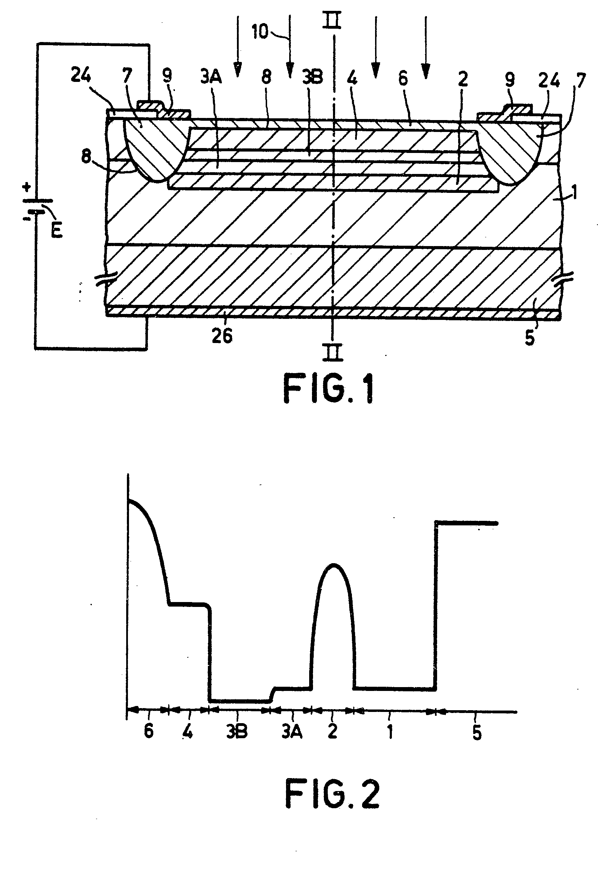

Fig. 1 is a diagrammatic cross-sectional view of a way of carrying out the invention. The device comprises an avalanche diode, in this example a photo-avalanche diode, for detecting radiation, in this example electromagnetic radiation having a wavelength of approximately 0.9 micron. The device comprises a semiconductor body having a semiconductor layer structure (1, 2, 3, 4) of a first conductivity type, in this example the p- conductivity type. Said layer structure comprises successively a first low-doped p-type semi-conductor layer 1 having a substantially homogeneous doping, a second p-type semiconductor layer 2 having a doping concentration which is higher than the doping concentration of the first semiconductor layer, and a third p-type semiconductor layer 3, in this example consisting of two parts 3A and 3B (see Fig. 1) having a lower doping concentration than the second semiconductor layer 2.

The layer structure which in addition comprises the p-type fourth semiconductor layer 4 to be described hereinafter is provided on one side, namely on the layer 1, with a first contact layer 5 (in this example a highly doped p-type semiconductor layer) which forms a non-rectifying junction with the first semiconductor layer 1, and is provided on the other side with a second contact layer 6 which forms a rectifying junction with the last semiconductor of the layer structure which, in this example, is the fourth semiconductor layer 4. In this example the second contact layer 6 consists of an n-type semiconductor layer which forms a planar p-n junction 8 with the p-type fourth semiconductor layer 4. However, it is by no means essential for the contact layers 5 and 6 to be semiconductor layers; for example, the first contact layer 5 may alternatively be a metal layer which is provided on the first semiconductor layer 1 and which forms a non-rectifying ohmic contact the the first semiconductor layer 1, while the second contact layer 6 may alternatively be a conductive layer which forms a rectifying (Schottky) junction with the fourth semiconductor layer 4. In this example, all semiconductor layers are silicon; the first semiconductor layer 1 has a resistivity of approximately 50 Ohm.cm (doping concentration $2.6.10^{14}$ atoms/cm³), the second semiconductor layer 2 has a maximum doping concentration of approximately $10^{16}$ atoms/cm³, and the third semiconductor layer 3 comprises a part 3A which is formed by a material of the first semiconductor layer 1 and a part 3B having a resistivity of approximately 160 ohm.cm (doping concentration approximately $8.10^{13}$ atoms/cm³).

The layer structure comprises between the second contact layer 6 and the third semiconductor layer 3 a fourth semiconductor layer 4, likewise of the p-conductivity type, having a doping concentration which is higher than that of the third semiconductor layer 3. In this example the doping of the fourth semiconductor layer 4 is substantially homogeneous, while the doping concentration is $7.10^{15}$ atoms/cm³. The semiconductor layers 1 and 2 constitute the drift region and the semiconductor layers 3 and 4 constitute the avalanche region of the photo-avalanche diode.

Fig. 2 shows diagrammatically the relative dopings of the various layers taken on the cross-sectional line II—II of Fig. 1. The device described is symmetrical, for instance rotationally symmetrical, with the line II—II of Fig. 1 as a symmetry axis; however, this is by no means necessary and numerous other geometries may be used without departing from the scope of this invention. The device furthermore comprises a belt-like zone 7 which extends from the surface down to the second semiconductor layer 2 and contacts the n-type second contact layer 6. The belt-like zone 7 adjoins the semiconductor layers 2, 3 and 4 along its whole inner circumference. Said belt-like zone serves to avoid edge breakdown at the p-n junction 8. A connection conductor in the form of a metal electrode layer 9 contacts the n-type region (6, 7), the metal layer 9 on the second contact layer 6 comprising a window through which electromagnetic radiation (10) can be incident on the second contact layer (6). The surface is partly covered with an insulating layer, for example a silicon oxide layer 24. The first contact layer 5 has a connection conductor in form of an electrode layer 26.

As shown in Fig. 1, in the operating condition the electrode layers 9 and 26 of the diode are connected to a voltage source E, so that the diode is biased in the reverse direction until a reverse voltage value occurs at which the desired avalanche multiplication occurs. For details regarding the physical action which is the same as in known photoavalanche diodes, reference is made to the relevant literature, for example, the above-mentioned article in Philips Technical Review vol. 36 (1976) *pp.* 205—210.

It has been found that in this diode the above-mentioned noise factor $k$ is approximately 0.01, whereas in the same diode in the same conditions and in the absence of the fourth semiconductor layer 4 it is approximately twice as large. This was established in a process in which the fourth semiconductor layer 4 was provided as last layer by ion implantation, by measuring the factor $k$ prior to and after providing the fourth semiconductor layer 4.

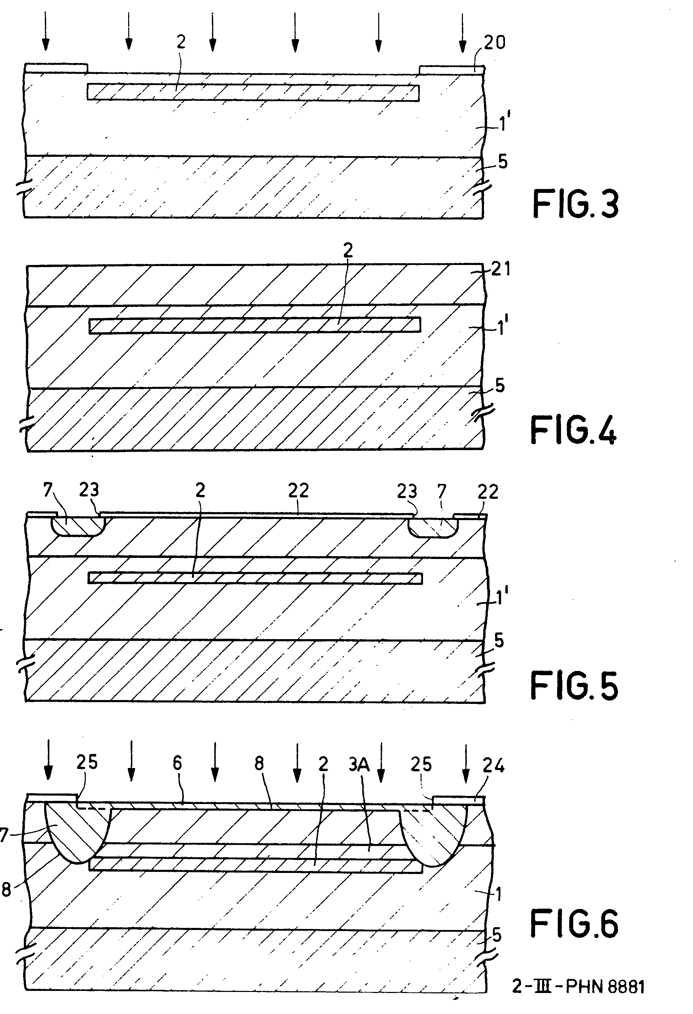

The manufacture of the device shown in Fig. 1 will now be described in greater detail with reference to Figs. 3 to 7.

First example.

Starting material (see Fig. 3) is a substrate of p-type silicon, preferably having a (100) orientation, with a doping of approximately $10^{19}$ atoms/cm³ and a thickness of approximately 250 microns. As the first epitaxial semiconductor layer 1' a p-type silicon layer having a thickness of 20 microns and a resistivity of 50 Ohm.cm (doping approximately $2.6.10^{14}$ atoms/cm³) is grown epitaxially hereon while using known methods which are generally used in semiconductor technology. A mask of an insulating layer 20 is then formed on the surface by means of known photolithographic methods, for example, a silicon oxide mask which can be obtained *inter alia* by thermal oxidation succeeded by etching with the use of a photolacquer mask.

While using the layer 20 as an implantation mask, a p-type second semiconductor layer 2 is then formed so that the structure shown in Fig. 3 is obtained. In this example this is carried out by implantation of boron ions with an energy of 160 KeV and a dose of $1.56.10^{12}$ ions per cm². However, other methods may alternatively be used for providing the layer 2. Furthermore, instead of a single implantation, two or more successive implantations may alternatively be carried out using different energies and doses. In this example the resulting second semiconductor layer 2 is situated at some distance below the surface. After implantation, there is annealed in an inert atmosphere, for example in argon or nitrogen, at approximately 800—900°C so as to recover the crystal damage done. The diameter of the (circular) window in the layer 20 and also of the second semiconductor layer 2 is, for example, 400 microns. Although in this example the layer does not extend up to the surface of the first epitaxial semiconductor layer 1', the second semiconductor layer 2 may alternatively be provided so that either already during the implantation or during the subsequent thermal treatments, it extends up to or even slightly over said surface.

The oxide layer 20 is then removed after which as the second epitaxial semiconductor layer 21 a further p-type silicon layer is provided on the surface by epitaxial growth. In this example the layer 20 has a thickness of 2.9 microns; the resistivity is approximately 160 Ohm.cm (doping approximately $8.10^{13}$ atoms/$cm^3$). The structure shown in Fig. 4 is then obtained.

The surface of the second epitaxial semiconductor layer 21 is then oxidized thermally at approximately 1050°C for 1 hour in moist oxygen. As a result of this the oxide layer 22 (see Fig. 5) is formed. A belt-like aperture 23 is etched in said oxide layer. While using the silicon oxide layer 22 as a mask, phosphorus is diffused via said belt-like aperture 23 so as to form the n-type belt-like zone 7. The surface concentration of the belt-like zone 7 is in this example approximately $10^{19}$ atoms/$cm^3$; the thickness in this stage of Fig. 5 is approximately 1.75 microns. For this purpose a phosphorus deposition at 975°C for approximately 20 minutes is carried out.

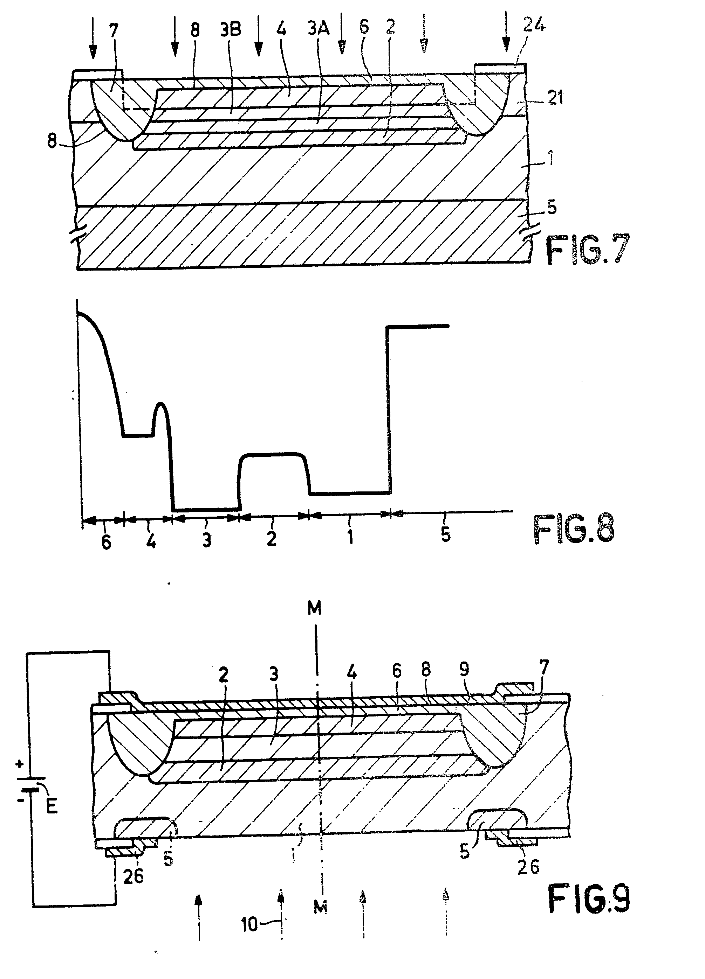

In order to give the belt-like zone 7 the desired thickness, the structure is now heated at approximately 1130°C in an oxidizing atmosphere. The belt-like zone 7 diffuses through the second epitaxial layer 21 down to the second semiconductor layer 2 (see Fig. 6). After this diffusion step an approximately 3 microns thick oxide layer 24 is provided on the whole surface in one or several steps by pyrolytic deposition from an atmosphere containing $SiH_4$ and oxygen. A window 25 is then etched in said thick oxide layer 24. Using the layer 24 as a masking layer, arsenic ions are then implanted through the window 25. This may be carried out in one or more implantation steps, for example, by a first implantation step of 30 KeV succeeded by a second implantation step of 80 KeV, both with a dose of $4.10^{14}$ ions per $cm^2$. Then the structure is annealed at 900°C for approximately 30 minutes in an inert atmosphere (argon or nitrogen). An approximately 0.25 micron thick n-type surface layer extending into the diffused guard ring 7 is thus obtained (see Fig. 6), which forms the second contact layer 6.

The fourth semiconductor layer 4 which is characteristic of the invention is then provided. For that purpose, in order to obtain the desired layer thickness and doping, in this example, 9 successive ion implantation steps are carried out in which boron ions are implanted with energies of successively 1000, 800, 675, 560, 435, 330, 240, 160 and 97 KeV, the dose in each implantation step being $9.10^{10}$ ions per $cm^2$. As a result of this a fourth semiconductor layer 4 is formed having a substantially homogeneous doping (see Fig. 2) of approximately $7.10^{15}$ atoms per $cm^3$ and a thickness of approximately 1.6 microns.

After the last annealing treatment to reduce the crystal lattice damage produced by the implantation of the fourth semiconductor layer 4, the annular electrode layer 9 and the electrode layer 26 can be provided in the usual manner by vapour-deposition or sputtering and etching. An anti-reflection layer (not shown) may also be provided on the second contact layer 6 on the side of the incident radiation 10.

The breakdown voltage of the diode thus manufactured was 150 volts.

During the process described, the noise of the diode was measured by means of pressure contacts immediately prior to and immediately after providing the fourth semiconductor layer 4. It was established that the factor k prior to the implantation of the fourth semiconductor layer 4 had a value of 0.020 and after the provision of the fourth semiconductor layer 4 had a value of approximately 0.014.

Second example.

In a second experiment, a first epitaxial layer 1' was grown epitaxially in a thickness of 22 microns and a resistivity of approximately 200 Ohm.cm (doping approximately $6.5.10^{13}$ atoms/$cm^3$). The second semiconductor layer 2 was provided by means of 9 boron implantations each with a dose of $8.4.10^{10}$ ions/$cm^2$ and energies of successively 1000, 800, 675, 560, 435, 330, 240, 160 and 97 KeV. As a result of this the doping of the second semiconductor layer 2 became substantially homogeneous and was $6.10^{15}$ atoms/$cm^3$; the thickness was 1.5 microns. The fourth semiconductor layer 4 was similarly provided by means of 9 boron implantations with energies of successively 1000, 800, 675, 560, 435, 330, 240, 260 and 97 KeV. The dose for the implantation at 1000 KeV was $3.10^{11}$ ions/$cm^2$, that of the remaining implantation steps was each time $4.5.10^{10}$ ions/$cm^2$. Thus the fourth semiconductor layer 4 obtained a thickness of approximately 1.6 microns with a region of increased doping concentration of at most approximately $2.10^{16}$ atoms/$cm^3$ near the boundary with the third semiconductor layer 3 and for the remaining part a substantially homogeneous doping of $6.10^{15}$ atoms/$cm^3$. The other process steps were the same as those of the first example. The breakdown voltage of the diode was 220 Volts, the factor k was 0.012. The doping profile is shown in Fig. 8.

Third example

In this example a first epitaxial layer 1' having a thickness of 20 microns and a resistivity of 46 Ohm.cm was grown. The second semiconductor layer 2 was provided with a single boron ion implantation at 160 KeV with a dose of $2.56.10^{12}$ ions/$cm^2$. The second epitaxial layer 21 had a thickness of 2.9 microns as in the first example, but a resistivity of 50 Ohm.cm, so approximately equal to that of the first epitaxial layer 1'. The fourth semiconductor layer 4 was provided in the same manner as the first example. The breakdown voltage was 220 volts and the factor $k$ was 0.009. The doping profile was analogous to that of Fig. 2.

It appears from these examples that planar photo-avalanche diodes with a very low noise factor can be obtained by using the structure according to the invention. However, the invention is not restricted to the examples described. The various layers may alternatively be provided in a manner other than indicated in as far as the relative mutual dopings according to the invention are observed.

The semiconductor material used may alternatively be different from silicon. In semiconductor materials in which ionisation coefficient $\alpha$ for electrons is larger than that ($\beta$) for holes at the same voltage, for example in silicon, the layer structure will preferably be $p$-type conductive, whereas in materials in which $\beta<\alpha$, for example germanium, said layers will preferably be $n$-type conductive.

Instead of the planar structure as described in the examples, a mesa structure may be used.

As the "second" contact layer a conductive layer which may or may not be metallic and which is no semiconductor layer, may be used, which conductive layer forms a rectifying junction with the "fourth" semiconductor layer.

Of importance also is the case in which, in contrast with the above-described examples, the first contact layer 5 which is provided on the first semiconductor layer 1, comprises a connection conductor in form of an electrode layer 26, having a window through which radiation can be incident on the layer structure. Such a modified embodiment is shown diagrammatically in the cross-sectional view of Fig. 9. The device of Fig. 9 is symmetric, for instance rotationally symmetric about the line M—M; with respect to Fig. 1, the same reference numerals denote corresponding components. The $p^+$ first contact layer 5 in this case is annular, as is the electrode layer 26; the radiation 10 is incident on the first semi-conductor layer 1.

It is to be noted that whereas Figs. 2 and 8 show abrupt transitions in doping concentration, said transitions are shown diagramatically and in practice they are more or less gradual.

Finally it is to be noted that where in this application implantation energies are mentioned, they relate to the number of KeV taking into account the ion charge. For example, an implantation with boron ions of 1000 KeV may be an implantation of singly-charged boron ions traversing a field of 1000 KV or of doubly-charged boron ions at 500 KV, etc.

## Claims

1. A semiconductor device having an avalanche diode for detecting radiation, comprising a semiconductor body having a semiconductor layer structure (1, 2, 3, 4) of a first conductivity type, which layer structure comprises successively at least a first semiconductor layer (1) of substantially homogeneous, low doping, a second semiconductor layer (2) having a doping concentration which is higher than the doping concentration of the first layer (1), and a third semiconductor layer (3) having a lower doping concentration than the second layer, a first contact layer (5) being present at one side of the layer structure (1, 2, 3, 4) and forming a non-rectifying junction with the neighbouring first semiconductor layer (1), a second contact layer (6) being present at a side of the layer structure (1, 2, 3, 4) opposite to said one side and forming a rectifying junction (8) with the neighbouring semiconductor layer of the layer structure (1, 2, 3, 4), characterized in that the layer structure (1, 2, 3, 4) comprises between the second contact layer (6) and the third semiconductor layer (3) a fourth semiconductor layer (4) of the first conductivity type having a doping concentration which is higher than that of the third semiconductor layer (3).

2. A semiconductor device as claimed in claim 1, characterized in that the fourth semiconductor layer (4) has a substantially homogeneous doping.

3. A semiconductor device as claimed in claim 1, characterized in that the fourth semiconductor layer (4) comprises a region of increased doping concentration near the boundary with the third semiconductor layer 3.

4. A semiconductor device as claimed in any of the preceding claims, characterized in that the fourth semiconductor layer (4) comprises implanted doping ions.

5. A semiconductor device as claimed in any of the preceding claims, characterized in that the third semiconductor layer (3) comprises an epitaxially grown layer.

6. A semiconductor device as claimed in any of the preceding claims, characterized in that the second semiconductor layer (2) comprises implanted doping ions.

7. A semiconductor device as claimed in any of the preceding claims, characterized in that the second contact layer (6) is formed by a semiconductor layer of the second conductivity type which forms a $p$-$n$ junction (8) with the fourth layer (4).

8. A semiconductor device as claimed in claim 7, characterized in that the $p$-$n$ junction (8) is a planar junction.

9. A semiconductor device as claimed in claim 8, characterized in that the second contact layer (6) is located between said semiconductor layer structure (1, 2, 3, 4) and a surface of the semiconductor body, a belt-like zone (7) of the second conductivity type being present which extends from said surface into the semiconductor body down to a larger depth than the second contact layer (6) and which along its whole inner circumference adjoins the second contact layer (6).

10. A semiconductor device as claimed in claim 9, characterized in that the belt-like zone

11 **0 001 139** 12

(7) adjoins the second, third and fourth semiconductor layers (2, 3, 4) along its whole inner circumference.

11. A semiconductor device as claimed in any of the preceding claims, characterized in that the first contact layer (5) is formed by a highly doped semiconductor layer of the first conductivity type.

12. A semiconductor device as claimed in any of the preceding claims, characterized in that a connection conductor (9) is electrically connected to the second contact layer (6), said connection conductor (9) having a window through which radiation (10) can be incident on the second contact layer (6).

13. A semiconductor device as claimed in any of the claims 1 to 11, characterized in that the first contact layer (5 in Fig. 9) is provided with a connection conductor (26) having a window through which radiation (10) can be incident on the layer structure (1, 2, 3, 4) of the first conductivity type.

14. A semiconductor device as claimed in any of the preceding claims, characterized in that the layer structure (1, 2, 3, 4) consists of a *p*-type conductive silicon layers.

15. A semiconductor device as claimed in any of the preceding claims, characterized in that the avalanche diode is a photoavalanche diode for detecting electromagnetic radiation.

16. A method of manufacturing a semiconductor device as claimed in any of the preceding claims, characterized in that starting material is a semiconductor substrate which serves as the first contact layer (5), that a low-doped first epitaxial semiconductor layer of the first conductivity type is grown on said substrate, that ions of a dopant determining the first conductivity type are implanted into said first epitaxial semiconductor layer so as to obtain first and second portions of the first epitaxial semiconductor layer which form the first (1) and second (2) semiconductor layer, that a second epitaxial semiconductor layer of the first conductivity type having a lower doping than the second semiconductor layer (2) is then grown on the first epitaxial semiconductor layer with the second semiconductor layer (2) implanted therein, that ions determining the first conductivity type are implanted into said second epitaxial semiconductor layer so as to obtain third and fourth portions of the second epitaxial semiconductor layer which form the third (3) and fourth (4) semiconductor layer.

17. A method as claimed in claim 16, characterized in that after the growth of the second epitaxial semiconductor layer the second contact layer (6) is formed by the introduction of ions determining the second conductivity type, after which the fourth semiconductor layer (4) is formed by implantation of ions determining the first conductivity type *via* the second contact layer (6).

18. A method as claimed in claim 16 or 17, characterized in that the fourth semiconductor layer (4) is formed by a number of successive ion implantations at different energies.

19. A method as claimed in any of the claims 16 to 18, characterized in that the second semiconductor layer (2) is formed by a number of successive ion implantations at different energies.

20. A method as claimed in any of the claims 16 to 18, characterized in that after the epitaxial growth of the second epitaxial semiconductor layer, first the belt-like zone (7) of the second conductivity type is diffused and that the second contact layer (6) is then implanted in a surface part which overlaps the inner circumference of the belt-like zone (7).

**Revendications**

1. Dispositif semiconducteur présentant une diode à avalanche pour détecter du rayonnement, muni d'un corps semiconducteur présentant une structure à couche semiconductrice (1, 2, 3, 4) d'un premier type de conduction, structure à couche qui comporte successivement au moins une première couche semiconductrice à faible dopage pratiquement homogène (1), une deuxième couche semiconductrice (2) présentant une concentration de dopage qui est plus élevée que la concentration de dopage de la première couche (1), et une troisième couche semiconductrice (3) présentant une concentration de dopage plus faible que celle de la deuxième couche, une première couche de contact (5) étant présente à une face de la structure à couche (1, 2, 3, 4) et forme une jonction non redresseuse avec la première couche semiconductrice voisine (1), une seconde couche de contact (6) étant présente à une face de la structure de couche (1, 2, 3, 4) opposée à ladite face et forme une jonction redresseuse (8) avec la couche semiconductrice voisins de la structure à couche (1, 2, 3, 4), caractérisé en ce qu'entre la deuxième couche de contact (6) et la troisième couche semiconductrice (3) la structure à couche (1, 2, 3, 4) comporte une quatrième couche semiconductrice (4) du premier type de conduction présentant une concentration de dopage qui est plus élevée que celle de la troisième couche semiconductrice (3).

2. Dispositif semiconducteur selon la revendication 1, caractérisé en ce que la quatrième couche semiconductrice (4) présente un dopage pratiquement homogène.

3. Dispositif semiconducteur selon la revendication 1, caractérisé en ce que la quatrième couche semiconductrice (4) comporte une région de concentration de dopage augmenté située près de la limite avec la troisième couche semiconductrice (3).

4. Dispositif semiconducteur selon l'une des revendications précédentes, caractérisé en ce que la quatrième couche semiconductrice (4) comporte des ions de dopage implantés.

5. Dispositif semiconducteur selon l'une des revendications précédentes, caractérisé en ce que la troisième couche semiconductrice (3) comporte une couche formée par croissance épitaxiale.

6. Dispositif semiconducteur selon l'une des revendications précédentes, caractérisé en ce que la deuxième couche semiconductrice (2) comporte des ions de dopage implantés.

7. Dispositif semiconducteur selon l'une des revendications précédentes, caractérisé en ce que la deuxième couche de contact (6) est formée par une couche semiconductrice du deuxième type de conduction, qui forme une jonction p-n (8) avec la quatrième couche (4).

8. Dispositif semiconducteur selon l'une des revendications 7, caractérisé en ce que la jonction p-n (8) est une jonction planaire.

9. Dispositif semiconducteur selon la revendication 8 caractérisé en ce que la deuxième couche de contact (6) se situe entre ladite structure à couche semiconductrice (1, 2, 3, 4) et une surface du corps semiconducteur, une zone en forme de bande (7) du second type de conduction étant présente et s'étend à partir de ladite surface jusque dans le corps semiconducteur sur une plus grande profondeur que la deuxième couche de contact (6) et se raccorde à la deuxième couche de contact (6) le long de toute sa periphérie interne.

10. Dispositif semiconducteur selon la revendication 9, caractérisé en ce que le long de toute sa periphérie interne, la zone en forme de bande (7) se raccorde à la deuxième, troisième et quatrième couche semiconductrice (2, 3, 4).

11. Dispositif semiconducteur selon l'une des revendications précédentes, caractérisé en ce que la première couche de contact 5 est formée par une couche semiconductrice à dopage élevé du premier type de conduction.

12. Dispositif semiconducteur selon l'une des revendications précédentes, caractérisé en ce qu'un conducteur de connexion (9) est connecté électriquement à la deuxième couche de contact (6), ledit connecteur de connexion (9) présentant une fenêtre par laquelle du rayonnement (10) peut atteindre la deuxième couche de contact (6).

13. Dispositif semiconducteur selon l'une des revendications 1 à 11, caractérisé en ce que la première couche de contact (5 sur la figure 9) est appliquée et munie de conducteurs de connexion (26) présentant une fenêtre par laquelle du rayonnement (10) peut atteindre la structure à couche (1, 2, 3, 4) du premier type de conduction.

14. Dispositif semiconducteur selon l'une des revendications précédentes, caractérisé en ce que la structure de couche (1, 2, 3, 4) est constituée par des couches de silicium du type de conduction p.

15. Dispositif semiconducteur selon l'une des revendications précédentes, caractérisé en ce que la diode à avalanche est une photodiode à avalanche pour la détection de rayonnement électro-magnétique.

16. Procédé pour la réalisation d'un dispositif semiconducteur selon l'une des revendications précédentes, caractérisé en ce que le matériau de départ est un substrat semiconducteur qui sert de première couche de contact (5), qu'une première couche semiconductrice épitaxiale faiblement dopée du premier type de conduction est formée par croissance sur ledit substrat, que des ions d'une substance de dopage déterminant le premier type de conduction sont implantés dans ladite première couche semiconductrice épitaxiale de façon à obtenir des première et second parties de la première couche semiconductrice épitaxiale, qui constituent les première et deuxième couches semiconductrices (1, 2) qu'une deuxième couche semiconductrice épitaxiale du premier type de conduction présentant un plus faible dopage que la deuxième couche semiconductrice (2) est formée par croissance sur la première couche semiconductrice épitaxiale présentant la deuxième couche semiconductrice (f2) formée par implantation dans cette dernière, que des ions déterminant le premier type de conduction sont implantés dans ladite deuxième couche semiconductrice épitaxiale de façon à obtenir les troisième et quatrième parties de la deuxième couche semiconductrice épitaxiale, qui constituent les troisième et quatrième couches semiconductrices (3, 4).

17. Procédé selon la revendication 16, caractérisé en ce qu'après la croissance de la deuxième couche semiconductrice épitaxiale, la deuxième couche de contact (6) est formée par introduction d'ions déterminant le second type de conduction, après quoi la quatrième couche semiconductrice (4) est formée par implantation d'ions déterminant le premier type de conduction par l'intermédiaire de la deuxième couche de contact (6).

18. Procédé selon la revendication 16 ou 17, caractérisé en ce que la quatrième couche semiconductrice (4) est formée par un nombre d'implantations d'ions successives à différentes énergies.

19. Procédé selon l'une des revendications 16 à 18, caractérisé en ce que la deuxième couche semiconductrice (2) est formée par un nombre d'implantations d'ions successives à différentes énergies.

20. Procédé selon l'une des revendications 16 à 18, caractérisé en ce qu'après la croissance épitaxiale de la deuxième couche semiconductrice épitaxiale, d'abord la zone en forme de bande (7) du second type de conduction est formée par diffusion et que la deuxième couche de contact (6) est ensuite formée par implantation dans une partie de surface qui chevauche la périphérie interne de la zone en forme de bande (7).

**Patentansprüche**

1. Halbleiteranordnung mit einer Lawinendiode zum Detektieren von Strahlung, die einen Halbleiterkörper mit einer Halbleiterschichtenstruktur (1, 2, 3, 4) von einem ersten Leitungstyp enthält, welche Schichtstruktur nacheinander mindestens eine erste Halbleiterschicht (1) mit einer nahezu homogenen niedrigen Dotierung, eine zweite Halbleiterschicht (2) mit einer die der ersten Schicht (1) überschreitenden Dotierungskonzentration und eine dritte Halbleitenschicht (3) mit einer die der zweiten Schicht unterschreitenden Dotierungskonzentration enthält, bei der eine erste Kontaktschicht (5) auf einer Seite der Schichtenstruktur (1, 2, 3, 4) vorhanden ist und einen nichtgleichrichtenden Uebergang mit den benachbarten ersten Halbleiterschicht (1) bildet, während eine zweite Kontaktschicht (6) auf einer der genannten einen Seite gegenüberliegenden Seite der Schichtenstruktur (1, 2, 3, 4) vorhanden ist und einen gleichrichtenden Uebergang (8) mit der benachbarten Halbleiterschicht der Schichtenstruktur (1, 2, 3, 4) bildet, dadurch gekennzeichnet, dass die Schichtenstruktur (1, 2, 3, 4) zwischen der zweiten Kontaktschicht (6) und der dritten Halbleiterschicht (3) eine vierte Halbleiterschicht (4) vom ersten Leitungstyp mit einer die der dritten Halbleiterschicht (3) überschreitenden Dotierungskonzentration enthält.

2. Halbleiteranordnung nach Anspruch 1, dadurch gekennzeichnet, dass die vierte Halbleiterschicht (4) eine nahezu homogene Dotierung aufweist.

3. Halbleiteranordnung nach Anspruch 1, dadurch gekennzeichnet, dass die vierte Halbleiterschicht (4) ein Gebiet mit erhöhter Dotierungskonzentration in der Nähe der Grenze mit der dritten Halbleiterschicht (3) enthält.

4. Halbleiteranordnung nach einem der vorhergehenden Ansprüche, dadurch gekennzeichnet, dass die vierte Halbleiterschicht (4) implantierte Dotierungsionen enthält.

5. Halbleiteranordnung nach einem der vorhergehenden Ansprüche, dadurch gekennzeichnet, dass die dritte Halbleiterschicht (3) eine epitaktisch angewachsene Schicht enthält.

6. Halbleiteranordnung nach einem oder mehreren der vorhergehenden Ansprüche, dadurch gekennzeichnet, dass die zweite Halbleiterschicht (2) implantierte Dotierungsionen enthält.

7. Halbleiteranordnung nach einem oder mehreren der vorhergehenden Ansprüche, dadurch gekennzeichnet, dass die zweite Kontaktschicht (6) durch eine Halbleiterschicht vom zweiten Leitungstyp gebildet wird, die einen PN-Uebergang (8) mit der vierten Schicht (4) bildet.

8. Halbleiteranordnung nach Anspruch 7, dadurch gekennzeichnet, dass der PN-Uebergang (8) ein planarer Uebergang ist.

9. Halbleiteranordnung nach Anspruch 8, dadurch gekennzeichnet, dass die zweite Kontaktschicht (6) sich zwischen der genannten Halbleiterschichtenstruktur (1, 2, 3, 4) und einer Oberfläche des Halbleiterkörpers befindet, und dass eine gurtförmige Zone (7) vom zweiten Leitungstyp vorhanden ist, die sich von der genannten Oberfläche bis in den Halbleiterkörper bis zu einer grösseren Tiefe als die zweite Kontaktschicht (6) erstreckt und die über ihren ganzen Innenumfang an die zweite Kontaktschicht (6) grenzt.

10. Halbleiteranordnung nach Anspruch 9, dadurch gekennzeichnet, dass die gurtförmige Zone (7) über ihren ganzen Innenumfang an die zweite, die dritte und die vierte Halbleiterschicht (2, 3, 4) grenzt.

11. Halbleiteranordnung nach einem der vorhergehenden Ansprüche, dadurch gekennzeichnet, dass die erste Kontaktschicht (5) durch eine hoch dotierte Halbleiterschicht vom ersten Leitungstyp gebildet ist.

12. Halbleiteranordnung nach einem der vorhergehenden Ansprüche, dadurch gekennzeichnet, dass ein Anschlussleiter (9) elektrisch mit der zweiten Kontaktschicht (6) verbunden ist, wobei dieser Anschlussleiter (9) mit einem Fenster versehen ist, über das Strahlung (10) auf die zweite Kontaktschicht (6) einfallen kann.

13. Halbleiteranordnung nach einem der Ansprüche 1 bis 11, dadurch gekennzeichnet, dass die erste Kontaktschicht (5 in Fig. 9) mit einem Anschlussleiter (26) versehen ist, der ein Fenster aufweist, über das Strahlung (10) auf die Schichtenstruktur (1, 2, 3, 4) vom ersten Leitungstyp einfallen kann.

14. Halbleiteranordnung nach einem der vorhergehenden Ansprüche, dadurch gekennzeichnet, dass die Schichtenstruktur (1, 2, 3, 4) aus p-leitenden Siliciumschichten besteht.

15. Halbleiteranordnung nach einem der vorhergehenden Ansprüche, dadurch gekennzeichnet, dass die Lawinendiode eine Photolawinendiode zum Detektieren elektro magnetischer Strahlung ist.

16. Verfahren zur Herstellung einer Halbleiteranordnung nach einem der vorhergehenden Ansprüche, dadurch gekennzeichnet, dass von einem Halbleitersubstrat ausgegangen wird, das als die erste Kontaktschicht (5) dient; dass eine niedrig dotierte erste epitaktische Halbleiterschicht vom ersten Leitungstyp auf dem genannten Substrat angewachsen wird; dass Ionen eines den ersten Leitungstyp bestimmenden Dotierungsmittels in die genannte erste epitaktische Halbleiterschicht implantiert werden, um einen ersten und einen zweiten Teil der ersten epitaktischen Halbleiterschicht zu erhalten, die die erste (1) und die zweite (2) Halbleiterschicht bilden; dass eine zweite epitaktische Halbleiterschicht vom ersten Leitungstyp mit einer die der zweiten Halbleiterschicht (2) unterschreitenden Dotierung dann auf der ersten epitaktischen Halbleiterschicht mit der darin implantierten zweiten Halbleiterschicht (2) angewachsen wird und dass den ersten Leitungstyp bestimmende Ionen in die genannte zweite epitaktische Halbleiterschicht implantiert werden, um einen dritten und einen vierten Teil der zweiten epitaktischen Halbleiterschicht zu erhalten, die die dritte (3) und die vierte (4) Halbleiterschicht bilden.

17. Verfahren nach Anspruch 16, dadurch gekennzeichnet, dass nach dem Anwachsen der zweiten epitaktischen Halbleiterschicht eine zweite Kontaktschicht (6) dadurch erzeugt wird, dass den zweiten Leitungstyp bestimmende Ionen eingeführt werden, wonach die vierte Halbleiterschicht (4) durch Implantation den ersten Leitungstyp bestimmender Ionen über die Kontaktschicht (6) erzeugt wird.

18. Verfahren nach Anspruch 16 oder 17, dadurch gekennzeichnet, dass die vierte Halbleiterschicht (4) durch eine Anzahl aufeinanderfolgender Ionenimplantation bei verschiedenen Energien erzeugt wird.

19. Verfahren nach einem der Ansprüche 16 bis 18, dadurch gekennzeichnet, dass die zweite Halbleiterschicht (2) durch eine Anzahl aufein-anderfolgender Ionenimplantionen bei verschiedenen Energien erzeugt wird.

20. Verfahren nach einem der Ansprüche 16 bis 18, dadurch gekennzeichnet, dass nach dem epitaktischen Anwachsen der zweiten epitaktischen Halbleiterschicht zunächst die gurtförmige Zone (7) vom zweiten Leitungstyp diffundiert wird, und dass dann die zweite Kontaktschicht (6) in einen Oberflächenteil implantiert wird, der den Innenumfang der gurtförmigen Zone (7) überlappt.

FIG.1

FIG.2

FIG.3

FIG.4

FIG.5

FIG.6

2-Ⅲ-PHN 8881

FIG.7

FIG.8

FIG.9

3